# FASCICULE DE BREVET EUROPEEN

(11) **EP 1 409 763 B1**
(45) Date de publication et mention de la délivrance du brevet: **28.09.2011**
(21) Numéro de dépôt: 01996635.7
(22) Date de dépôt: 08.11.2001
(51) Int. Cl.: C23C 14/54, C23C 16/52

(54) **PROCEDE ET DISPOSITIF DE DEPOT DE COUCHES MINCES**
VERFAHREN UND VORRICHTUNG ZUR ABSCHEIDUNG DÜNNER FILME
METHOD AND DEVICE FOR DEPOSITING THIN FILMS

(30) Priorité: 16.11.2000 FR 0014775
(43) Date de publication de la demande: 21.04.2004
(73) Titulaire: COMPAGNIE INDUSTRIELLE DES LASERS CILAS, 45100 Orléans (FR)
(72) Inventeur: GREZES-BESSET, Catherine, F-13013 Marseille (FR)
(74) Mandataire: Bonnetat, Christian
(86) Numéro de dépôt international: PCT/FR2001/003461
(87) Numéro de publication internationale: WO 2002/040737

(56) Documents cités:
- EP-A2- 1 170 396
- EP-A2- 1 170 396
- FR-A- 2 281 996
- JP-A- 01 239 028
- JP-A- 01 239 028
- US-A- 4 582 431
- US-A- 5 354 575
- PATENT ABSTRACTS OF JAPAN vol. 004, no. 119 (C-022), 23 août 1980 (1980-08-23) & JP 55 076064 A (FUJITSU LTD), 7 juin 1980 (1980-06-07)
- ZHOU Z H ET AL: "REAL-TIME IN SITU EPITAXIAL FILM THICKNESS MONITORING AND CONTROL USING AN EMISSION FOURIER TRANSFORM INFRARED SPECTROMETER" JOURNAL OF VACUUM SCIENCE AND TECHNOLOGY: PART A,US,AMERICAN INSTITUTE OF PHYSICS. NEW YORK, vol. 12, no. 4, PART 02, 1 juillet 1994 (1994-07-01), pages 1938-1942, XP000463483 ISSN: 0734-2101

## Description

La présente invention est relative à un procédé et à un dispositif de dépôt de couches minces.

Le domaine technique de l'invention est celui de la fabrication de dispositifs optiques à couches minces.

L'invention s'applique particulièrement à la fabrication de filtres optiques essentiellement constitués par un empilement de couches minces successivement déposées sur un substrat plan.

Cette fabrication fait habituellement appel à une technique de dépôt sur le substrat ou sur l'empilement, à l'intérieur d'une enceinte dans laquelle on maintient une pression faible, généralement dite «enceinte sous vide», d'un matériau pour constituer chaque couche, par «évaporation» ou «sublimation» d'une «source» de ce matériau, suivie d'une «condensation» du même matériau sur une «cible» constituée par le substrat ou l'empilement en cours de réalisation; à cet effet, on utilise par exemple un ou plusieurs canon(s) à électrons ou canon(s) à ions.

La maîtrise des performances optiques du dispositif à couches minces nécessite la maîtrise de l'épaisseur de chaque couche déposée avec une précision suffisante pour que l'erreur sur l'épaisseur soit minime, en particulier inférieure à 1%.

Dans ce but, différentes méthodes de contrôle de l'épaisseur d'une couche en cours de dépôt ont été développées.

Une méthode «mécanique» consiste à placer une structure résonnante telle qu'un quartz, près d'un substrat destiné à recevoir les couches minces, dans l'enceinte sous vide, avant le démarrage du processus de dépôt; sur cette structure se dépose le matériau «évaporé» au fur et à mesure de l'avancement du processus de dépôt, de façon supposée identique au dépôt du matériau sur le substrat; le dépôt sur cette structure conduit à une modification de ses fréquences propres de résonance; la mesure d'au moins une de ces fréquences propres donne une indication (indirecte) de l'épaisseur de la couche déposée sur la structure résonnante, que l'on suppose identique à celle déposée sur le substrat; cette méthode indirecte du contrôle de l'épaisseur des couches minces déposées ne permet pas d'obtenir la précision souhaitée.

Il existe des méthodes «optiques» de contrôle de l'épaisseur de couches minces en cours de dépôt, qui sont généralement basées sur la mesure de l'évolution au cours du temps de la transmission ou de la réflexion d'un faisceau lumineux qui est dirigé vers l'empilement en cours de fabrication; parmi ces technique de contrôle optique, on distingue celles dans lesquelles le faisceau lumineux est monochromatique, celles dans lesquelles le faisceau lumineux est bi-chromatique, celles dans lesquelles le faisceau lumineux est multi-chromatique et celles dans lesquelles le faisceau lumineux est «large bande».

Les techniques utilisant une ou deux longueurs d'onde sont particulièrement adaptées au contrôle d'épaisseurs optiques d'empilements quart d'onde; la technique utilisant un faisceau large bande est, à l'inverse, bien adaptée aux empilements dont les épaisseurs optiques ne sont pas quart d'onde; dans la technique monochromatique, on recherche un extremum de la transmission, généralement par calcul de la dérivée temporelle de la transmission, et on commande l'arrêt du dépôt de matière lorsque cette dérivée s'annule; on peut aussi commander l'arrêt du dépôt lorsque la dérivée partielle du facteur de transmission par rapport à l'épaisseur optique s'annule.

Dans une technique bi-chromatique, on commande généralement l'arrêt du dépôt en fonction de la valeur mesurée de la différence de transmission aux deux longueurs d'ondes considérées.

Dans une technique large bande, on asservit généralement le dépôt en fonction de la différence entre un spectre de transmission prédéterminé et un spectre de transmission mesuré au cours du dépôt.

Dans une technique multi-chromatique, on détermine, préalablement au dépôt, une pluralité de longueurs d'onde pour chacune desquelles la transmission d'une couche de l'empilement présente un extremum lorsque l'épaisseur optique désirée est atteinte.

En pratique (voir par exemple FR-A-2 281 996), on contrôle l'épaisseur déposée sur un substrat témoin (ou substrat de référence) qui, lorsqu'on effectue simultanément un dépôt sur plusieurs substrats disposés sur un support commun mis en rotation, est éloigné desdits substrats : il en résulte que la précision du contrôle n'est pas suffisante.

Le brevet US-5 425 964 décrit une méthode de contrôle optique large bande.

Le brevet US-4 311 725 décrit un procédé et un dispositif de mesure et de contrôle du dépôt d'une couche mince qui combinent une méthode mécanique et une méthode optique ou électrique : le contrôle du dépôt est basé sur le rapport entre un signal délivré par un quartz soumis au dépôt et un signal représentatif de la transmission, de la réflexion ou de la résistivité de la couche mince en cours de dépôt.

Le document JP-01 239 028 A décrit un dispositif de dépôt simultané de couches minces sur plusieurs substrats montés sur un support rotatif. Des moyens de production et de détection d'un faisceau lumineux permettent le contrôle individuel de l'épaisseur optique de chaque substrat et servent à régler la vitesse de rotation du support en forme de couronne.

Par ailleurs, le document EP-A-1 170 396 A décrit, en partie implicitement, un dispositif pour le dépôt simultané de couches minces sur une pluralité de substrats, ledit dispositif comportant, à l'intérieur d'une enceinte sous faible pression :
- une source apte à émettre dans ladite enceinte de la vapeur de la matière constitutive desdites couches minces ;
- un support rotatif sur lequel sont disposés en commun lesdits substrats ; et
- des moyens de contrôle optique aptes à mesurer l'épaisseur desdites couches minces pendant leur formation sur lesdits substrats.

Dans un tel dispositif connu par le document EP-A-1 1 70 396 A, bien que tous les substrats d'un lot subissant ledit dépôt simultané de couches minces se présentent apparemment de façon identique, on constate que les dépôts de couches minces peuvent varier d'un substrat à l'autre. A la fin dudit dépôt, on obtient donc un lot de substrats non identiques, ce qui est préjudiciable à une fabrication par lots.

Ainsi, bien que les procédés et les dispositifs connus de contrôle du dépôt d'une couche mince puissent, pour certaines applications, présenter des performances suffisantes, d'autres applications, en particulier la fabrication de filtres optiques passe-bande à structure multicouche pour le traitement de signaux de télécommunication, nécessitent des performances accrues.

L'objet de la présente invention est de remédier à cet inconvénient en perfectionnant la technique antérieure.

A cette fin, selon l'invention, le dispositif pour le dépôt simultané de couches minces sur une pluralité de substrats, ledit dispositif comportant, à l'intérieur d'une enceinte sous faible pression :
- une source apte à émettre dans ladite enceinte de la vapeur de la matière constitutive desdites couches minces ;
- un support rotatif sur lequel sont disposés en commun lesdits substrats ; et
- des moyens de contrôle optique aptes à mesurer l'épaisseur desdites couches minces pendant leur formation sur lesdits substrats,
   est remarquable :
- en ce que lesdits moyens de contrôle optique sont aptes à mesurer l'épaisseur de chaque couche mince individuellement ; et
- en ce qu'il comporte des moyens pour modifier sélectivement la vitesse de dépôt sur chaque substrat individuellement en fonction des mesures individuelles effectuées par lesdits moyens de contrôle optique.

Lesdits moyens de modification sélective de la vitesse de dépôt peuvent comporter des cales mobiles ou déformables, disposées entre lesdits substrats et ledit support rotatif commun et aptes à permettre le déplacement sélectif de chaque substrat. De telles cales peuvent être piézoélectriques et commandées par des actionneurs individuels disposés à l'extérieur de ladite enceinte.

Lesdits moyens de modification sélective de la vitesse de dépôt peuvent également comporter des écrans mobiles, respectivement associés auxdits substrats ou bien des canons à ions ou à électrons, respectivement associés auxdits substrats.

Avantageusement, le dispositif conforme à la présente invention comporte une unité électronique reliée auxdits moyens de contrôle optique et apte à commander lesdits moyens de modification sélective de la vitesse de dépôt sous la dépendance desdits moyens de contrôle optique.

Lesdits moyens de contrôle optique peuvent comporter une source lumineuse unique émettant un faisceau lumineux unique et un diviseur produisant, à partir dudit faisceau lumineux unique, des faisceaux lumineux individuels pour lesdits substrats.

Ainsi, on peut mesurer une propriété optique telle que la transmittance ou la réflectance, de plusieurs couches minces (CM) ou de plusieurs empilements de couches minces qui sont en cours de formation par dépôt sous vide sur plusieurs substrats (ou portions de substrat), à l'aide de plusieurs faisceaux lumineux, chacun desdits faisceaux lumineux étant respectivement dirigé vers un desdits substrats ; on peut ainsi déterminer ladite propriété optique pour chacune desdites CM ou desdits empilements de CM et commander sélectivement (pour chacune desdites CM ou desdits empilements de CM) la modification et/ou l'arrêt du dépôt.

Grâce à l'utilisation sensiblement simultanée de plusieurs faisceaux lumineux de contrôle respectivement associés aux couches minces en cours de dépôt sur plusieurs substrats, on peut mesurer et contrôler individuellement le dépôt sur plusieurs substrats, ce qui permet d'améliorer l'uniformité des dépôts ainsi formés.

Puisque les faisceaux lumineux individuels de contrôle sont obtenus par division d'un faisceau lumineux primaire unique, les faisceaux de contrôle présentent des caractéristiques homogènes sinon identiques, ce qui simplifie le traitement des faisceaux (après transmission ou réflexion par les dispositifs en cours de fabrication).

La division du faisceau primaire unique en plusieurs faisceaux de contrôle peut être effectuée de manière temporelle ; ceci peut être obtenu de façon simple en déplaçant les substrats dans l'enceinte sous vide, au cours du processus de dépôt, de façon à ce que chacun des substrats (empilements) soit successivement placé sur le trajet dudit faisceau unique ; de cette façon, les substrats ou empilements à contrôler formant un hacheur ("shutter") du fait de leur mouvement, le faisceau réfléchi ou transmis forme successivement autant de faisceaux de contrôle que le nombre de substrats (ou empilements) l'ayant traversé.

De préférence, le mouvement des substrats et empilements est effectué de façon sensiblement continue, le long d'un contour fermé de forme circulaire en maintenant tous les substrats à une distance sensiblement constante de la source, afin de favoriser un dépôt continu et homogène du matériau formant la couche mince ; à cet effet, les substrats peuvent être montés sur un support en forme de couronne circulaire mis en rotation uniforme, selon son axe de révolution, pendant la durée du dépôt.

Avantageusement, on équipe le support commun rotatif d'un arbre creux à l'intérieur duquel le faisceau primaire peut se propager, ainsi que d'un organe de déviation du faisceau primaire, tel qu'un périscope solidaire du support, afin de dévier le faisceau primaire et le diriger de façon à ce qu'il traverse un des substrats disposés sur le support.

De préférence, on provoque l'interception du faisceau primaire par chaque substrat ou empilement à une fréquence constante et suffisamment élevée pour provoquer au moins plusieurs centaines, milliers ou dizaines de milliers desdites interceptions au cours du dépôt d'une couche mince ; en particulier, on provoque de 900 à 90 000 interceptions pour chaque couche mince.

On effectue ainsi pour chaque empilement plusieurs centaines ou milliers de mesures de ladite propriété optique, ce qui permet de contrôler avec une précision meilleure que 1 % l'épaisseur optique de la couche déposée.

Ladite division temporelle du faisceau primaire pour former lesdits faisceaux de contrôle peut également être obtenue par un mouvement de balayage desdits empilements par ledit faisceau primaire ; dans ce cas, les empilements peuvent être montés fixes ou mobiles dans l'enceinte.

En variante, les faisceaux de contrôle individuels peuvent être formés par division fréquentielle du faisceau primaire ; à cet effet, on peut notamment disposer un prisme sur le trajet du faisceau primaire pour former plusieurs faisceaux ou polychromatiques à partir d'un faisceau polychromatique primaire unique.

La division du faisceau primaire en faisceaux individuels peut également être spatiale et réalisée à l'aide de lames semi-réfléchissantes par exemple.

Ces différents moyens pour diviser le faisceau primaire en plusieurs faisceaux de contrôle individuels peuvent être combinés entre eux ; ils peuvent également être utilisés pour diviser plusieurs faisceaux primaires.

Selon l'invention, on peut utiliser lesdites techniques optiques mono, bi, pluri-chromatique ou large bande ; cependant, on utilise de préférence la technique mono ou bi-chromatique pour la fabrication de filtres WDM étroits, la technique pluri-chromatique pour la fabrication de filtres anti-reflets, et la technique large bande pour la fabrication de composants devant présenter un spectre particulier.

Afin de simplifier la réalisation opto-mécanique du dispositif de fabrication, le diviseur de faisceau est de préférence monté à l'intérieur de l'enceinte sous vide.

Grâce au contrôle sélectif et individuel du dépôt sur les substrats formant un lot, on peut fabriquer simultanément des composants ayant des caractéristiques optiques différentes, en enregistrant celles-ci avant la fabrication dans une mémoire associée au dispositif électronique de contrôle du dépôt ; ceci permet de fabriquer à moindre coût des composants en petite série.

D'autres caractéristiques et avantages de l'invention apparaissent dans la description suivante qui se réfère aux dessins annexés, qui illustrent sans aucun caractère limitatif des modes préférentiels de réalisation de l'invention.
La figure 1 illustre schématiquement, en vue de côté, un dispositif de fabrication de filtres optiques par dépôt de couches minces conforme à l'invention.
La figure 2 est une vue schématique partielle en perspective du dispositif selon une variante de réalisation.
La figure 3 est une vue schématique partielle d'une autre variante de réalisation des moyens de contrôle optique systématique des substrats d'un lot de substrats en cours de traitement.
Les figures 4 à 6 illustrent schématiquement 3 variantes de réalisation de moyens de maîtrise individuelle du dépôt sur les substrats.

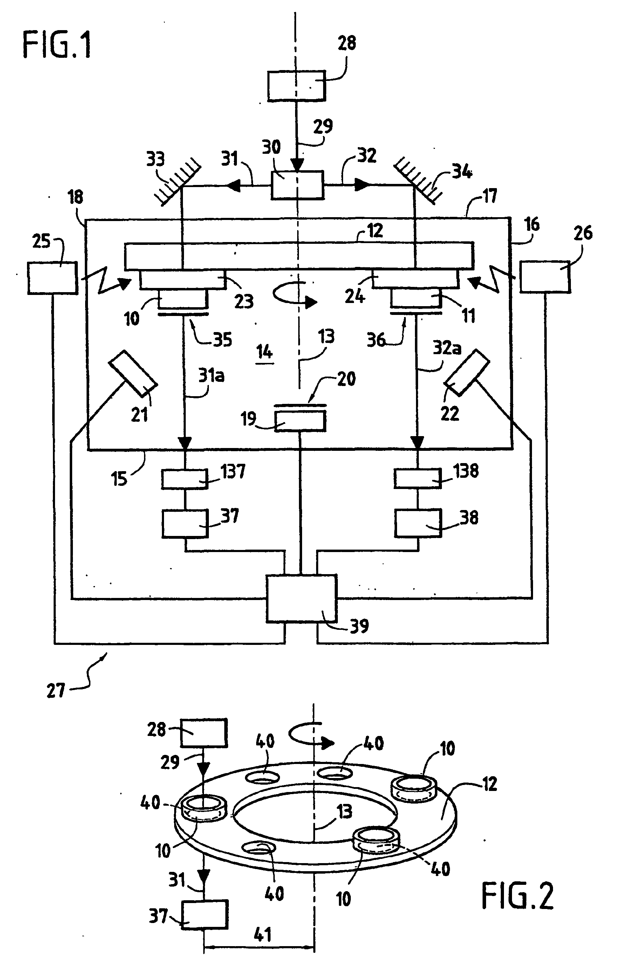

Par référence à la figure 1 en particulier, deux substrats 10 et 11 sont supportés par un support 12 commun qui est monté rotatif (selon l'axe 13) à l'intérieur de l'enceinte 14 sous vide.

L'enceinte 14 est délimitée par des parois étanches 15 à 18; elle renferme un support 19 d'une source 20 de matériau à déposer sur les substrats, ainsi que deux canons à ions 21, 22. Un mécanisme 23, 24 est respectivement intercalé entre le substrat 10, 11 et le support 12 rotatif commun aux substrats; chaque mécanisme translateur 23, 24 peut être activé à distance, sans contact, au travers des parois 18, 16, par un actionneur 25, 26 respectivement disposé en regard du translateur correspondant; l'activation de chaque mécanisme 23, 24 permet de déplacer le substrat 10, 11 correspondant d'une première position à une seconde position dans laquelle la vitesse de dépôt sur le substrat est différente de la vitesse de dépôt dans la première position, du fait de l'éloignement (ou, au contraire, du rapprochement) du substrat par rapport à la source 19, 20.

Le dispositif 27 de fabrication comporte un dispositif 28 d'émission d'un faisceau lumineux primaire 29 se propageant parallèlement à (et/ou confondu avec) l'axe 13 de rotation du support 12.

Le rayonnement 29 émis par la source 28 peut être monochromatique dans le cas d'une source laser, ou large bande dans le cas d'une source de lumière blanche ; ce rayonnement peut être pulsé, par exemple en intercalant sur le trajet du faisceau 29 un hâcheur ou "shopper" (non représenté), dont la fréquence de pulsation soit grande devant la fréquence de passage des substrats devant le faisceau de contrôle ; ceci peut permettre d'améliorer le rapport signal sur bruit de la mesure.

Un diviseur 30 est disposé sur le trajet du faisceau 29 et produit en sortie deux faisceaux 31, 32 lumineux, qui sont respectivement dirigés vers les substrats 10, 11 par des guides optiques 33, 34 (miroirs).

Le faisceau 31, 32 de contrôle traverse le substrat 10, 11 respectivement ainsi que l'empilement 35, 36 de couches minces en cours de dépôt en se propageant sensiblement avec une incidence normale au plan du substrat et des couches minces; chaque faisceau de contrôle incident 31, 32 forme en sortie un faisceau transmis 31a, 32a qui est respectivement mesuré par un détecteur 37, 38 par exemple constitué par un spectrographe.

De préférence, un filtre optique tel qu'un mono-chromateur 137, 138 est prévu sur le trajet des faisceaux 31a, 32a en amont de chaque détecteur 37, 38 ; ce filtre permet de diminuer et d'éliminer une partie au moins du rayonnement parasite, en particulier la lumière ambiante susceptible de perturber la mesure faite par le détecteur.

Une unité électronique 39 de contrôle et de commande du dispositif est reliée à la source 19, 20 pour commander l'évaporation du matériau à déposer, ainsi qu'aux canons 21, 22 pour moduler la vitesse de dépôt sur les substrats; l'unité 39 est également reliée aux actionneurs 25, 26 pour commander le déplacement de chaque substrat, ainsi qu'aux détecteurs 37, 38 pour analyser les signaux délivrés par ces détecteurs qui sont représentatifs de la propriété optique de chaque empilement en cours de fabrication.

A titre d'exemple, le faisceau primaire monochromatique est émis en continu et est divisé temporellement ou spatialement par le diviseur 30; chaque faisceau monochromatique 31, 32 de contrôle est modifié en traversant l'empilement; l'analyse de la transmittance de l'empilement par l'unité 39 est effectuée en comparant les signaux délivrés par les détecteurs avec des données enregistrées (alternativement un détecteur supplémentaire -non représenté- peut être placé sur le trajet de chaque faisceau 31, 32 de contrôle, en amont de l'empilement, et être raccordé à l'unité 39 pour la détermination de la transmittance).

L'analyse de l'évolution au cours du temps de l'avancement du processus de dépôt est effectuée selon les techniques habituelles rappelées en préambule, pour déterminer individuellement pour chaque substrat l'épaisseur optique de la couche en cours de dépôt afin de commander par les moyens décrits ci avant la diminution de la vitesse de dépôt et/ou l'arrêt du dépôt.

Selon une variante (non représentée) du dispositif illustré figure 1, un seul faisceau (commuté) de contrôle peut être prévu.

Par référence à la figure 2, le support 12 de substrat est monté rotatif selon l'axe 13 et est en forme de couronne percée de 6 fenêtres transparentes pour les faisceaux 29, 31; ce support est apte à recevoir 6 substrats 10 dont 3 sont représentés sur la figure 2. Dans ce mode de réalisation, le faisceau primaire 29 émis par la source 28 traverse successivement les substrats au fur et à mesure de leur passage dans l'alignement de la source 28 et du détecteur 37; à cet effet, la distance 41 séparant l'axe du faisceau 29 à l'axe 13 est égale à l'excentration des fenêtres 40 prévues dans le support 12.

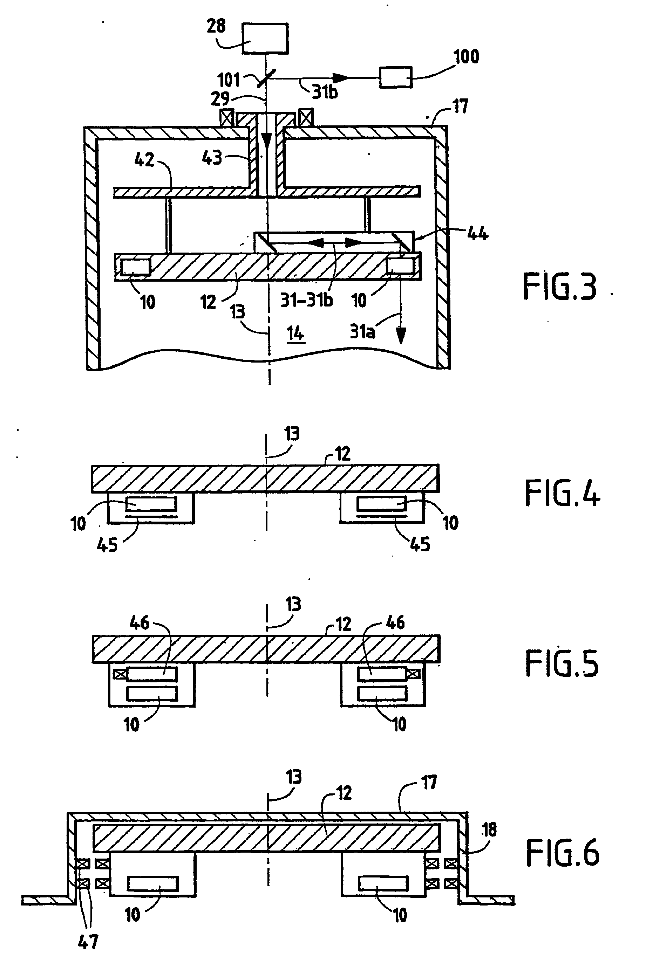

Par référence à la figure 3, le support 12 portant les substrats 10 est suspendu à un plateau support 42 en forme de disque solidaire d'un arbre creux 43 d'axe 13, l'ensemble étant monté rotatif selon cet axe grâce à un palier étanche prévu dans la paroi 17 de l'enceinte 14; le faisceau 29 émis par la source 28, se propage selon l'axe 13 à l'intérieur de l'arbre creux, jusqu'à l'entrée d'un dispositif 44 de déviation de type périscope, qui est monté sur le support 12 et est associé à un substrat.

Le dispositif 44 de déviation à miroir permet de diriger le faisceau de contrôle depuis l'axe 13 de propagation du faisceau 29, jusqu'à la normale au substrat 10 disposé à distance de l'axe 13 ; le dispositif 44 est fixé au support 12 ; le support 12 peut être équipé de plusieurs dispositifs 44 de déviation identiques ; de tels dispositifs à miroir permettent en outre de guider la partie 31 b du faisceau 31 qui est réfléchie par le substrat 10, jusqu'à une lame 101 semi-réfléchissante qui dirige le faisceau réfléchi à l'entrée d'un détecteur optique 100 ; ceci permet la mesure en continu de la réflectance du composant 10 qui peut être combinée avec la mesure de la transmittance du même composant par mesure faite sur le faisceau transmis 31 a ; cette mesure combinée de deux propriétés optiques du composant en cours de fabrication permet d'améliorer la précision du contrôle optique.

Dans la réalisation selon la figure 4, un écran 45 mobile et/ou amovible est associé à chaque substrat de façon à pouvoir être disposé en regard de chaque substrat, pour provoquer l'arrêt du dépôt et de façon à pouvoir être éloigné du substrat pour autoriser le dépôt.

Dans la réalisation selon la figure 5, une cale 46 piezoélectrique est insérée entre le support 12 et chaque substrat 10 pour pouvoir déplacer celui-ci en fonction de signaux de commande et influencer ainsi la vitesse de dépôt.

Selon une variante illustrée figure 6, cette cale réglable peut être remplacée par une interface mécanique 48 de liaison entre chaque substrat et le support 12, cette interface pouvant faire passer le substrat d'une première à une seconde position, par exemple par basculement sous la commande d'ergots 47 prévus proéminents sur la face interne de la paroi 18 de l'enceinte 14.

Dans le cas correspondant notamment au système des figures 1 et 2, où un des détecteurs 37, 38 (fixe) reçoit successivement les signaux de contrôle transmis par plusieurs substrats, le démultiplexage du faisceau de contrôle doit être effectué; celui-ci peut être par exemple fait sous la commande d'un signal de synchronisation lié à la rotation du support de substrat, ou bien par fenêtrage dynamique et auto corrélation du signal délivré par le détecteur 37, 38.

La fréquence de rotation du support 12 est de préférence située dans une plage allant de 1 à 60 hz, et la fréquence d'échantillonnage du signal délivré par les détecteurs 37, 38 est de préférence supérieure ou égale à 10 khz, en particulier située dans une plage allant de 10 khz à 100 khz.

Grâce aux moyens de mesure et de maîtrise individuelle de dépôt de matière sur tous les substrats d'un lot, on peut également augmenter le nombre de substrats traités simultanément et augmenter corrélativement la surface totale de substrat traitée.

## Revendications

1. Dispositif pour le dépôt simultané de couches minces (35, 36) sur une pluralité de substrats (10, 11), ledit dispositif comportant, à l'intérieur d'une enceinte sous faible pression (14) :
- une source (19, 20) apte à émettre dans ladite enceinte de la vapeur de la matière constitutive desdites couches minces ;
- un support rotatif (12) sur lequel sont disposés en commun lesdits substrats (10, 11) ; et
- des moyens de contrôle optique (28, 29, 37, 38) aptes à mesurer l'épaisseur desdites couches minces pendant leur formation sur lesdits substrats,
**caractérisé :**
- **en ce que** lesdits moyens de contrôle optique (28, 29, 37, 58) sont aptes à mesurer l'épaisseur de chaque couche mince individuellement ; et
- **en ce qu'**il comporte :
• des moyens (21 à 26, 45 à 48) pour modifier sélectivement la vitesse de dépôt sur chaque substrat (10, 11) individuellement en fonction des mesures individuelles effectuées par lesdits moyens de contrôle optique ; et
• une unité électronique (39) reliée auxdits moyens de contrôle optique (28, 29, 37, 38) et apte à commander lesdits moyens (21 à 26 et 45 à 48) de modification sélective de la vitesse de dépôt sous la dépendance desdits moyens de contrôle optique (28, 29, 37, 38).

2. Dispositif selon la revendication 1,
**caractérisé en ce que** lesdits moyens de modification sélective de la vitesse de dépôt comportent des cales (23, 24. 46, 48) mobiles ou déformables, disposées entre lesdits substrats (10, 11) et ledit support rotatif commun (12) et aptes à permettre le déplacement sélectif de chaque substrat

3. Dispositif selon la revendication 2,
**caractérisé en ce que** lesdites cales (23, 24. 46) sont piézoélectriques.

4. Dispositif selon la revendication 3
**caractérisé en ce que** lesdites cales piézoélectriques (23, 24, 46) sont commandées par des actionneurs individuels (25, 26) disposés à l'extérieur de ladite enceinte (14).

5. Dispositif selon l'une des revendications 1 à 4,
**caractérisé en ce que** lesdits moyens de modification sélective de la vitesse de dépôt comportent des écrans mobiles (45), respectivement associés auxdits substrats (10, 11).

6. Dispositif selon l'une des revendications 1 à 5,
**caractérisé en ce que** lesdits moyens de modification sélective de la vitesse de dépôt comportent des canons à tons ou à électrons (21, 22), respectivemnent associés audits substrats (10, 11).

7. Dispositif selon l'une des revendications 1 à 6,
**caractérisé en ce que** lesdits moyens de contrôle optique comportent une source lumineuse unique (28) émettant un faisceau lumineux unique (29) et un diviseur (30) produisant, à partir dudit faisceau lumineux unique (29), des faisceaux lumineux individuels (31, 32) pour lesdits substrats (10, 11).

## Claims

1. Device for simultaneously depositing thin layers (35, 36) on a plurality of substrates (10, 11), said device comprising, inside a chamber under low pressure (14)
- a source (19, 20) capable of emitting into said chamber vapour of the material forming said thin layers,
- a rotatable support (12) on which said substrates (10, 11) are arranged together, and
- optical control means (28, 29, 37, 38) capable of measuring the thickness of said thin layers during the formation thereof on said substrates,
**characterised**
- **in that** said optical control means (28, 29, 37, 58) are capable of measuring the thickness of each thin layer individually; and
- **in that** it comprises :
• means (21 to 26, 45 to 48) for selectively modifying the rate of deposition on each substrate (10, 11) individually as a function of individual measurements taken by said optical control means, and
• an electronic unit (39) connected to said optical control means (28, 29, 37, 38) and capable of controlling said means (21 to 26 and 45 to 48) for selectively modifying the rate of deposition depending on said optical control means (28, 29, 37, 38)

2. Device according to claim 1, **characterised in that** said means for selectively modifying the rate of deposition comprise mobile or deformable blocks (23, 24, 46, 48) arranged between said substrates (10, 11) and said common rotatable support (12) and capable of allowing the selective displacement of each substrate

3. Device according to claim 2, **characterised in that** said blocks (23, 24, 46) are piezoelectric

4. Device according to claim 3, **characterised in that** said piezoelectric blocks (23, 24, 46) are controlled by individual actuators (25, 26) arranged outside said chamber (14)

5. Device according to any one of claims 1 to 4, **characterised in that** said means for selectively modifying the rate of deposition comprise mobile screens (45), respectively associated with said substrates (10, 11)

6. Device according to any one of claims 1 to 5, **characterised in that** said means for selectively modifying the rate of deposition comprise ion or electron guns (21, 22), respectively associated with said substrates (10, 11)

7. Device according to any one of claims 1 to 6, **characterised in that** said optical control means comprise a single light source (28) emitting a single light beam (29) and a splitter (30) producing, from said single light beam (29), individual light beams (31, 32) for said substrates (10, 11)

## Patentansprüche

1. Vorrichtung zum gleichzeitigen Aufbringen von dünnen Schichten (35, 36) auf eine Vielzahl von Substraten (10, 11), wobei die besagte Vorrichtung im Inneren eines geschlossenen Raumes unter geringem Druck (14) folgendes umfasst
- eine Quelle (19, 20), die in der Lage ist, im besagten Raum Dampf des Materials freizusetzen, aus dem die besagten dünnen Schichten bestehen,
- einen drehenden Trager (12), auf dem die besagten Substrate (10, 11) gemeinsam angeordnet sind; und
- Vorrichtungen zur optischen Prufung (28, 29, 37, 38), die in der Lage sind, die Starke der besagten dünnen Schichten wahrend ihrer Bildung auf den besagten Substraten zu messen,
**dadurch gekennzeichnet**
- **dass** die besagten Vorrichtungen zur optischen Prufung (28, 29, 37, 38) in der Lage sind, die Starke jeder dünnen Schicht einzeln zu messen, und
- **dadurch**, dass sie folgendes umfasst
• Vorrichtungen (21 bis 26, 45 bis 48) zum selektiven Andern der Aufbringgeschwindigkeit einzeln auf jedes Substrat (10, 11), in Abhangigkeit von den verschiedenen durchgeführten Messungen durch die besagten Vorrichtungen zur optischen Prufung, und
• eine Elektronikeinheit (39), die an die besagten Vorrichtungen zur optischen Prufung (28, 29, 37, 38) angeschlossen, und die in der Lage ist, die besagten Vorrichtungen (21 bis 26, 45 bis 48) zur selektiven Anderung der Aufbringgeschwindigkeit unter dem Einfluss der besagten Vorrichtungen zur optischen Prufung (28, 29, 37, 38) zu steuern

2. Vorrichtung nach Anspruch 1,
**dadurch gekennzeichnet, dass** die besagten Vorrichtungen zum selektiven Andern der Aufbringgeschwindigkeit bewegliche oder verformbare Klötze (23, 24, 46, 48) umfassen, die zwischen den besagten Substraten (10, 11) und dem besagten gemeinsamen drehenden Trager (12) angeordnet sind, und die in der Lage sind, das selektive Verfahren eines jeden Substrats zu ermöglichen

3. Vorrichtung nach Anspruch 2,
**dadurch gekennzeichnet, dass** die besagten Klötze (23, 24, 46) piezoelektrisch sind

4. Vorrichtung nach Anspruch 3,
**dadurch gekennzeichnet, dass** die besagten piezoelektrischen Klötze (23, 24, 46) von einzelnen Stellorganen (25, 26) angesteuert werden, die außerhalb des besagten geschlossenen Raumes (14) angeordnet sind.

5. Vorrichtung nach einem der Anspruche 1 bis 4,
**dadurch gekennzeichnet, dass** die besagten Vorrichtungen zum selektiven Andern der Aufbringgeschwindigkeit bewegliche Abschirmungen (45) umfassen, die jeweils den besagten Substraten (10, 11) zugeordnet sind.

6. Vorrichtung nach einem der Anspruche 1 bis 5,
**dadurch gekennzeichnet, dass** die besagten Vorrichtungen zum selektiven Andern der Aufbringgeschwindigkeit lonen- oder Elektronenstrahler (21, 22) umfassen, die jeweils den besagten Substraten (10, 11) zugeordnet sind

7. Vorrichtung nach einem der Anspruche 1 bis 6,
**dadurch gekennzeichnet, dass** die besagten Vorrichtungen zur optischen Prufung eine einzige Lichtquelle (28) umfassen, die einen einzigen Lichtstrahl (29) abgibt, und einen Teiler (30), der aus dem besagten einzigen Lichtstrahl (29) einzelne Lichtstrahlen (31, 32) fur die besagten Substrate (10, 11) erzeugt
